# EUROPEAN PATENT APPLICATION

(11) **EP 4 198 162 A1**
(43) Date of publication of application: **21.06.2023**
(21) Application number: 21306800.0
(22) Date of filing: 16.12.2021
(51) Int. Cl.: C23C 14/04, C23C 14/50, C23C 14/22, C23C 14/26, C23C 14/30

(54) **PHYSICAL VAPOR DEPOSITION MACHINE WITH A SHUTTER HAVING AT LEAST ONE INTERMEDIATE POSITION**

(71) Applicant: Essilor International, 94220 Charenton-Le-Pont (FR)
(72) Inventor: HENKY, Francis, 21000 DIJON (FR)
(74) Representative: Ipsilon

(57) **Abstract**

The invention concerns a physical vapor deposition machine for depositing a coating onto at least one article, comprising:
- at least one vaporization means and/or at least one ion gun configured to generate a flow of ions or vaporized material towards a carrousel configured to receive a plurality of articles,
- at least one shutter of said flow of ions or vaporized material comprising at least one screen movable between a first and a second positions,
said at least one shutter of said flow of ions or vaporized material is configured to be positioned and locked at at least one intermediate position between said first and second positions, wherein said at least one screen prevents a predetermined area projected onto said carrousel to be reached by said flow of ions or vaporized material when said shutter is in said at least one intermediate position.

## Description

The invention concerns a physical vapor deposition machine. Particularly, the invention concerns a physical vapor deposition machine for depositing a coating onto at least one article, for example an ophthalmic lens. The invention further concerns a method for physical vapor deposition using such physical vapor deposition machine.

Layer deposition is a process applied in many industries to form coating so as to protect surfaces and/or to impart a variety of desired properties to said surfaces. For example, in optics, an antireflective or anti-reflection (AR) coating is a type of optical coating applied to the surface of lenses or other optical devices to reduce reflection.

Physical Vapor Deposition is a well-known process performed under vacuum. In an embodiment of a physical vapor deposition process, a target consisting of a material is bombarded with an energy beam provided by an electron beam gun. The energy beam causes atoms from the target to transform into the gaseous phase. These atoms then precipitate into solid form, coating one substrate or simultaneously a plurality of substrates in a vacuum container with a layer of the material.

Vapor deposition machine may also comprise a thermal evaporator to provide a topcoat to the substrates.

Each of these vaporization means, i.e. the electron beam gun or the thermal evaporator, are configured to generate a flow of vaporized material towards a plurality of substrates. The physical vapor deposition machine may also comprise an ion gun for providing a flow of ions towards the plurality of substrates, e.g. for densification of a layer or for activating a surface of the substrate before depositing a coating. When the optical coating is a multilayer stack, bombardment can be implemented during deposition of all layers or only some of them. Bombardment can also be implemented after deposition of one or several layers of the stack, generally for improving adhesion between the layers.

Each of these vaporization means and ion gun generally comprises a two-position shutter able to either prevent any substrate to be reached or allows all substrates to be reached by said flow of ions or vaporized material. In other words, these shutters are on/off shutters. These shutters are usually mechanically movable.

The number of substrates that can be reached by the flow of ions or vaporized material in a single operating cycle is not fully satisfactory with the existing physical vapor deposition machines. Indeed, the known process lacks flexibility in use and the number of substrates on the carrousel is limited.

Furthermore, the distribution management of the coating deposited onto the substrates is complex with this kind of existing machine. Indeed, the substrates are disposed onto a rotating circular carousel which faces the vaporization means during operation. The substrates are generally arranged in concentric circles to be able to coat a maximum of substrates for each operation cycle. However, the substrates which are positioned near the center of the carrousel are much more exposed to vapor deposition than substrates which are positioned far from this center. It is thus important to manage the coating distribution of the substrates to make it sure that all substrates have the same coating features.

There is a need for an improved physical vapor deposition machine which allows more substrates to be coated with the same efficiency while improving the distribution management of the deposition.

To solve this problem, the invention provides a physical vapor deposition machine for depositing a coating onto at least one article, comprising:
- a chamber forming a base surface,
- a crucible assembly disposed on said base surface,
- a carrousel configured to receive a plurality of articles disposed thereto so as to face said crucible assembly, said carrousel being configured to be rotated with regard to said crucible assembly,
- at least one vaporization means and/or at least one ion gun configured to generate a flow of ions or vaporized material towards the carrousel,
- at least one shutter of said flow of ions or vaporized material comprising at least one screen movable between:
   - a first position wherein said at least one screen prevents any article disposed onto said carrousel to be reached by said flow of ions or vaporized material,
   - a second position wherein said at least one screen allows all articles disposed onto said carrousel to be reached by said flow of ions or vaporized material,
   said physical vapor deposition machine being characterized in that said at least one shutter of said flow of ions or vaporized material is configured to be positioned and locked at at least one intermediate position between said first and second positions, wherein said at least one screen prevents a predetermined area projected onto said carrousel to be reached by said flow of ions or vaporized material when said shutter is in said at least one intermediate position.

The at least one shutter of said flow of ions or vaporized material is configured to have at least three positions including one for preventing the articles to be coated (i.e. an Off position), one for allowing all the articles to be coated (i.e. an On position and at least one intermediate position for preventing only predetermined area of the carrousel to be coated. It is therefore possible de manage the distribution of the ions or vaporized material depending on the position, orientation and/or shape of the predetermined area projected onto said carrousel. This distribution management may be obtained depending on the characteristics of the shutter. These characteristics may comprise one or more among the position, the orientation, the material and/or the shape of the screen of the shutter.

Improving distribution management allows to increase to the number of articles disposed onto the carrousel while maintaining the efficiency of the deposition process, notably by adapting the shape of the screen.

Furthermore, it is possible to use a shutter which is already present in a physical vapor deposition machine to lower the costs of such a distribution management.

According to an embodiment of the physical vapor deposition machine, said shutter of said flow of ions or vaporized material prevents at least part, but not all, of the articles disposed onto said carrousel to be reached by said flow of ions or vaporized material when disposed in said at least one intermediate position.

According to an embodiment of the physical vapor deposition machine, said at least one vaporization means comprises one or more among an electron beam gun and a thermal evaporator.

According to an embodiment of the physical vapor deposition machine, it comprises a controller for controlling the position of the shutter, said controller being further configured to set said at least one intermediate position of the shutter.

According to an embodiment of the physical vapor deposition machine, said carrousel is configured to receive said plurality of articles in the form of a plurality of concentric rows, said predetermined projected area covering at least a part of at least one row of said plurality of concentric rows of said carrousel.

According to an embodiment of the physical vapor deposition machine, said predetermined projected area covers at least a part of all rows of said carrousel.

According to an embodiment of the physical vapor deposition machine, said carrousel is configured to be rotated around a rotation axis, said plurality of concentric rows being arranged around said rotation axis from a center portion to a peripheral portion of said carrousel, said predetermined projected area extending from said center to said peripheral portion.

According to an embodiment of the physical vapor deposition machine, said predetermined projected area defines a covering rate corresponding to a number of articles covered by said at least one screen divided by a total number of articles in a row, said at least one screen is formed so that the covering rate of each row among said plurality of rows decreases from the center to the peripheral portions.

According to an embodiment of the physical vapor deposition machine, a distance is defined between said base surface corresponding to 0% and said carrousel corresponding to 100%, said shutter of said flow of ions or vaporized material being disposed between 0 and 50% of said distance.

According to an embodiment of the physical vapor deposition machine, it further comprises a mask positioned nearby said carrousel and configured to prevent an additional predetermined projected area of said carrousel to be reached by said flow of ions or vaporized material.

According to an embodiment of the physical vapor deposition machine, said mask is disposed between 70% and 100% of said distance.

According to an embodiment of the physical vapor deposition machine, said flow of ions or vaporized material forms a cone of ions or vaporized material with a cone apex positioned at the base surface and a cone base positioned at the carrousel.

According to an embodiment of the physical vapor deposition machine, said shutter comprises:
- a first screen configured to prevent any article disposed onto said carrousel to be reached by said flow of ions or vaporized material when disposed between said carrousel and said at least one vaporization means or said at least one ion gun,
- a second screen configured to prevent said predetermined area of said carrousel to be reached by said flow of ions or vaporized material when disposed between said carrousel and said at least one vaporization means or said at least one ion gun,
said shutter being configured to be moved to either position said first or said second screens between said crucible assembly and said carrousel.

The invention also provides a method for depositing a coating onto at least one article using a physical vapor deposition machine which comprises:
- a chamber forming a base surface,
- a crucible assembly disposed on said base surface,
- a carrousel configured to receive a plurality of articles disposed thereto so as to face said crucible assembly, said carrousel being configured to be rotated with regard to said crucible assembly,
- at least one vaporization means and/or at least one ion gun configured to generate a flow of vaporized material towards said carrousel,
- at least one shutter of said flow of ions or vaporized material comprising at least one screen movable between:
   - a first position wherein said at least one screen prevents any article disposed onto said carrousel to be reached by said flow of ions or vaporized material,
   - a second position wherein said at least one screen allows all articles disposed onto said carrousel to be reached by said flow of ions or vaporized material,
   said physical vapor deposition machine being characterized in that said at least one shutter of said flow of ions or vaporized material is configured to be positioned and locked at at least one intermediate position between said first and second positions wherein said at least one screen prevents a predetermined area projected onto said carrousel to be reached by said flow of ions or vaporized material when said shutter is in said at least one intermediate position,
   said method comprising the following steps:
   - disposing at least one article onto said carrousel,
   - positioning and locking said at least shutter at said at least one intermediate position,
   - activating said at least one ion gun or at least one vaporization means to respectively generate a flow of ions or vaporized material towards said carrousel, said at least one shutter preventing said predetermined projected area of said carrousel to be reached by said flow of ions or vaporized material.

The invention is described in more detail below by way of the figures that show only one preferred embodiment of the invention.
Figure 1 shows a machine for physical vapor deposition comprising a vacuum container, a thermal evaporator, a ion gun and a crucible assembly therein.
Figure 2 shows a detailed view of the vacuum container of the machine for physical vapor deposition.
Figure 3 shows an exploded view of the crucible assembly comprising a base and a crucible connected together, a support and a crucible cover.
Figure 4 shows a two-position shutter for the thermal evaporator, the crucible assembly or the ion gun, in two positions.
Figure 5 shows a shutter for the thermal evaporator, the crucible assembly or the ion gun, having at least three positions including at least two intermediate positions, in two positions.
Figure 6 shows two embodiments of a shutter for the thermal evaporator, the crucible assembly or the ion gun including one with a cut-out.
Figure 7 shows two embodiments of a shutter for the thermal evaporator, the crucible assembly or the ion gun which comprise a first and a second screens.
Figure 8 shows two embodiments of a shutter for the thermal evaporator, the crucible assembly or the ion gun having one or more screens in the form of a crescent.

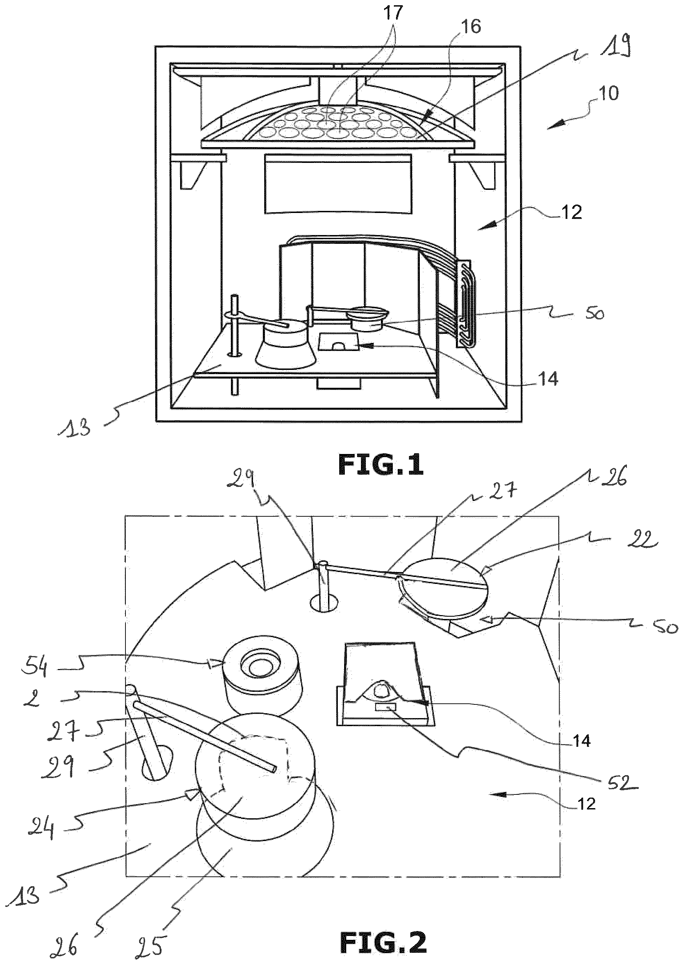

As shown on figures 1 and 2, a physical vapor deposition machine 10 comprises a chamber 12 which can be selectively put under vacuum. The physical vapor deposition machine 10 comprises a crucible assembly 14 disposed within the chamber 12 as well as a thermal evaporator 50, an electron beam gun 52 and an ion gun 54. The thermal evaporator 50 and the electron beam gun 52 are known as vaporization means.

The thermal evaporator 50 is configured to heat up a material to obtain a flow of vaporized material. This flow of vaporized material obtained with the thermal evaporator 50 may provide a coating onto a surface. This coating may be a topcoat.

The electron beam gun 52 is configured to vaporize material received into the crucible assembly 14 to provide a flow of vaporized material. This flow of vaporized material obtained with the electron beam gun 52 may provide a coating onto a surface. This coating may be an anti-reflective layer.

The ion gun 54 is configured to provide a flow of ions towards a surface. This flow of ions may be used for densification of a layer or for activating a surface of a substrate before depositing a coating.

The chamber 12 defines a base surface 13 onto which the crucible assembly 14, the thermal evaporator 50, the electron beam gun 52 and the ion gun 54 are disposed.

The physical vapor deposition machine 10 also comprises a carrousel 16 configured to receive a plurality of articles 17 to be coated by a flow of vaporized material or reached by a flow of ions. Particularly, the carrousel 16 is disposed within the chamber 12 and faces the base surface 13, i.e. the thermal evaporator 50, the electron beam gun 52 and the ion gun 54.

The articles 17 are disposed onto a receiving surface 19 of the carrousel 16 which faces the base surface 13. The carrousel 16 is preferably concave so as to direct all the articles 17 towards the crucible assembly 14. The carrousel 16 may be bell-shaped with the articles 17 disposed onto an inner surface of this bell.

In a preferred embodiment, the articles 17 are ophthalmic lenses.

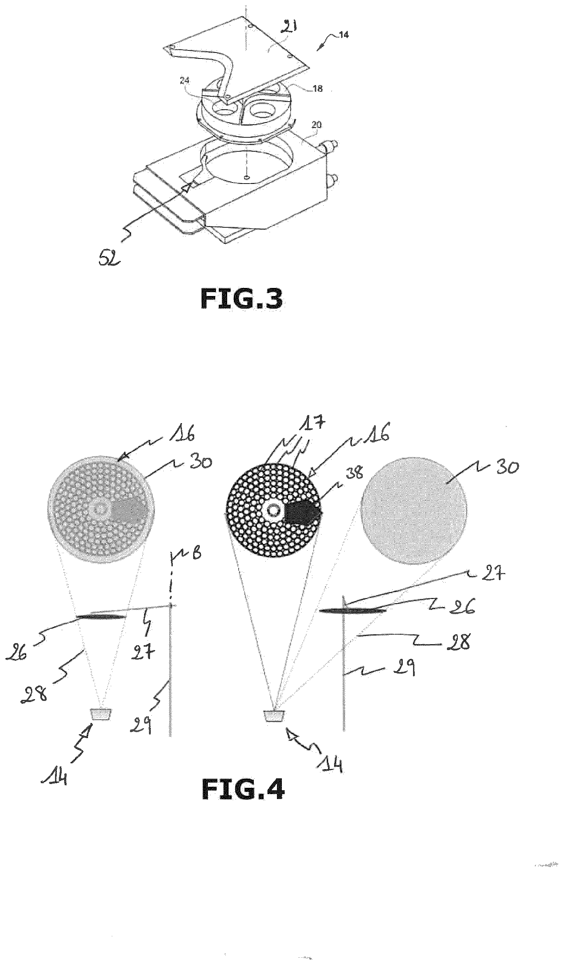

As shown on figure 3, said crucible assembly 14 comprises a crucible 18 configured to receive material to be vaporized within a plurality of cavities 24, a support 20 and a crucible cover 21 intended to be disposed above the crucible 18 to cover at least one of the cavities 24. The electron beam gun 52 is disposed near a portion of the crucible 18 which is not covered by the crucible cover 21.

Said physical vapor deposition machine 10 further comprises at least one shutter of said flow of ions or vaporized material. Preferably, said physical vapor deposition machine comprises a shutter for each of the thermal evaporator 50, the electron beam gun 52 and the ion gun 54. Hence, this shutter may be a first shutter 22 configured to shut the flow of vaporized material obtained with the electron beam gun 52, a second shutter 24 configured to shut the flow of ions obtained with the ion gun 54 or a third shutter (not shown) configured to shut the flow of vaporized material obtained with the thermal evaporator 50. The physical vapor deposition machine 10 may comprise at least one among the first 22, the second 24 and the third shutters.

All these shutters comprise a screen 26 configured to be disposed through the flow or ions or vaporized material. In other words, the screen 26 is configured to be positioned between the carrousel 16 and the vaporization means. Particularly, these shutters are movable between:
- a first position wherein said screen 26 prevents any article 17 disposed onto said carrousel 16 to be coated by said flow of ions or vaporized material,
- a second position wherein said screen 26 allows all articles 17 disposed onto said carrousel 16 to be coated by said flow of ions or vaporized material.

These first and second positions respectively correspond to Off and On positions of the shutter. The screen 26 may be moved between first and second positions by rotation. Alternatively, the screen 26 may be displaceable by translation.

In figure 2, each of the first 22 and the second 24 is shown in the second position (On position) wherein all articles can be reached by a flow of ions or vaporized material.

This screen 26 may be mounted at the end of an arm 27 which is onto a post 29. This post 29 may be rotatable around a shutter axis B to position the screen 26. The second shutter 24 of the ion gun 54 further comprises a skirt 25 allowing to at partially surround the ion gun 54. The skirt 25 forms a cavity for receiving the ion gun 54. A cutout 31 made in the skirt 25 allows the ion gun 54 to enter or leave said cavity when the second shutter 24 is displaced.

As can be seen on figure 4, a flow of vaporized material flows from the crucible assembly 14, particularly a cavity 24 containing material, towards the carrousel 16. For the sake of clarity, said cavity 24 is shown on side view and said carrousel 16 is shown from below on figure 4. Said flow of vaporized material forms a cone 28 of vaporized material with a cone apex positioned at the base surface 13, or at the crucible assembly 14, and a cone base positioned at the carrousel 16.

In figures 4 to 8, only a flow of vaporized material generated by the electron beam gun 52 is shown as an example for the sake of conciseness. The same flow of vaporized material generated by the thermal evaporator 50 and the flow of ions generated by the ion gun 54 could be shown and illustrated. The flow of vaporized material generated by the thermal evaporator 50 defines a cone of vaporized material having a cone apex positioned at the base surface 13, or at the thermal evaporator 50, and a cone base positioned at the carrousel 16. Similarly, the flow of ions generated by the ion gun 54 defines a cone of ions having a cone apex positioned at the base surface 13, or at the ion gun 54, and a cone base positioned at the carrousel 16.

The second 24 and third shutters have the same functioning as the first shutter 22 which is illustrated on figures 4 to 8. All the features described below with regard to the shutter may apply to the first 22, second 24 and the third shutters. Indeed, all these shutters comprise a screen 26 on top of the shutter, as shown in these figures.

The shutter is in the first position on the left of figure 4 and in the second position on the right. No article 17 can be coated in the first position whereas all articles 17 can be coated in the second position. In an example referring to the second shutter 24 of the ion gun 54, the flow of ions reaches the articles in the second position of the shutter whereas no article is reached by the flow of ions in the first position of the shutter.

A shut area 30 is defined by the projection of the screen 26 of the shutter onto the carrousel 16. In the first position, this shut area 30 covers all the articles 17 of the carrousel 16 whereas it does not cover even partly the carrousel 16 when disposed in the second position.

These shutters are also configured to be positioned and locked at at least one intermediate position between said first and second positions. In this intermediate position, said screen 26 prevents a predetermined area projected onto said carrousel to be reached by said flow of ions or vaporized material when said shutter is in said at least one intermediate position. Said predetermined area correspond to a position of said shut area 30 between the first and second positions, i.e. when it covers only a part of the carrousel 16.

Said shutter is thus configured to prevent at least part, but not all, of the articles 17 disposed onto said carrousel 16 to be reached by said flow of ions or vaporized material when disposed in said intermediate position.

The intermediate position corresponds to an angular or linear position of the screen 26 between the first and the second positions.

In a preferred embodiment, the shutter is configured to be positioned and locked at a plurality of intermediate positions to simplify distribution management. In doing so, the screen 26 may be positioned to allow multiple positions of the shut area 30 wherein only a part of the articles 17 are covered by said shut area 30.

Positioning and locking of the shutter into a specific position may be performed by a stepper motor controlled by a controller. In doing so, it is possible to communicate to the controller the intermediate position to make the shutter stopped and locked at a set-point intermediate position. Locking may be performed by the motor or by an independent locking device which may be also connected to the controller.

The position of the shutter allows to manage the distribution of the ions or vaporized material with less precision than with a mask or a shutter disposed near the carrousel 16. Indeed, the distance between the screen 26 and the carrousel 16 provides a gradient of masking at the edge of the shut area 30. It is thus not required that the shape of the screen 16 is precise.

Using the shutter for distribution management is very practical because the shutter is near the base surface 13 and thus very accessible for a user, especially with regard to a mask as described below. Furthermore, the shutter is a very robust device so that distribution management can be performed in a simple way without adding to the machine 10 a complex device. Distribution management can thus be reliable.

The screen 26 of the shutter is disposed between the vaporization means and the carrousel 16, near the base surface 13. A distance is defined between the base surface 13 corresponding to 0% and said carrousel 16 corresponding to 100%. Said shutter of said flow of ions or vaporized material is disposed between 0 and 50% of said distance. Particularly, these percentage are considered using the screen 26 of the shutter.

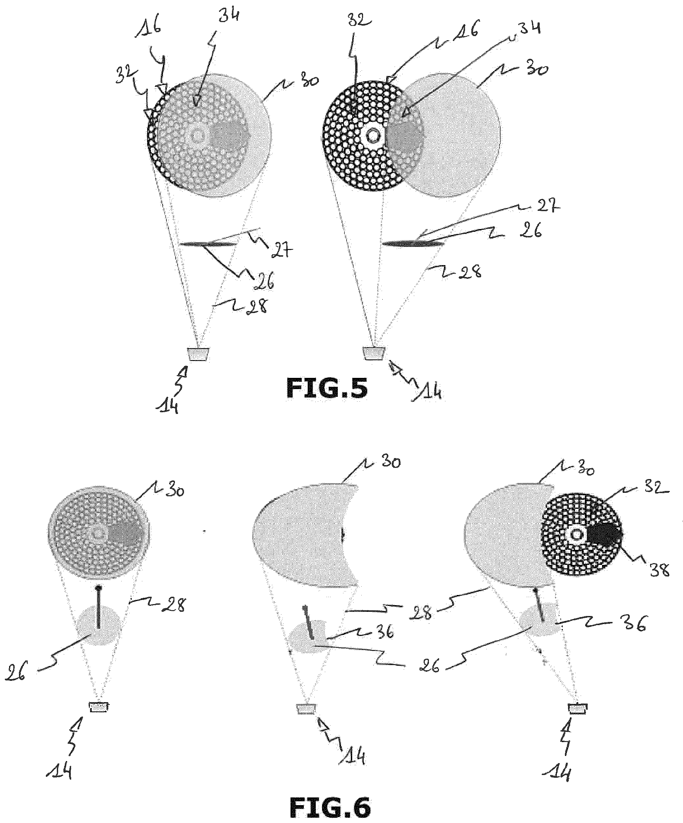

The shutter is shown on figure 5 in two different intermediate positions. Particularly, a first and a second intermediate positions are respectively shown on the left and on the right of figure 5. In these first and second intermediate positions, a first portion 32 of the articles 17 is not covered by the shut area 30 thus allowing the articles 17 disposed within this first portion 32 to be reached. To the contrary, a second portion 34 of the articles 17 is covered by the shut area 30 so the articles disposed within this second portion 34 cannot be reached. It is thus possible to choose the articles 17 to be reached depending on the position, orientation or shape of the screen 26.

In a preferred embodiment, the physical vapor deposition machine 10 comprises an indexing means configured to stop the screen 26 in one or more predetermined positions.

Distribution management of the ions or vaporized material can thus be performed depending on the angular or linear position of the intermediate position and/or the shape of the screen 26. In figure 5, we see that the intermediate position is predetermined to cover all rows of articles 17 except a part of the peripheral row of articles 17. It is thus possible to provide a coating only on this specific row of articles 17.

The articles 17 are preferably disposed onto the carrousel 16 in concentric circles from a central to a peripheral portions of the carrousel 16. The carrousel 16 is rotating during coating process to make the coating more homogeneous. The central portion of the carrousel 16 is defined around an axis of rotation A of the carrousel 16.

Figure 5 shows how to manage distribution of the deposition by varying the position of the screen 26 of the shutter while using a circular screen 26. Figure 6 shows how to manage distribution of the deposition by using a specific shape of the screen 26.

In figure 6, a first embodiment of the shutter is shown on the left with a circular screen 26 in an Off position wherein all articles 17 are covered by the shut area 30. In the center and on the right of figure 6, a second embodiment of the shutter is shown, respectively in an Off position and in an intermediate position.

We can see that a circular screen 26 can provide a shut area 30 which exactly fits the edges of the carrousel 16 when provided in the Off position. In the second embodiment, the screen 26 has cutout 36 which provides the shut area 30 with the same cutout. This cutout defines a recess which allows in the intermediate position to cover only some of the articles 17. Particularly, the second portion 34 within the articles are covered is shaped as a croissant so that only a peripheral row of articles 17 is covered in the intermediate position.

We can see from figures 4 and 5 that the shape and the position of the screen 26 allows to selectively prevent or allow one or more concentric rows of articles 17 disposed onto the carrousel 16 to be reached by a flow of ions or vaporized material. In figure 5, only a row of articles 17 can be reached by ions or vaporized material. To the contrary, a single row of articles 17 is covered by the shut area 30 so that all the remaining articles 17 can be reached except the articles covered by the shut area 30.

To limit the uneven distribution of ions or vaporized material onto the articles 17 depending on the position thereof on the carrousel 16, the physical vapor deposition may comprise a mask 38. Said mask 38 is positioned nearby said carrousel 16 and configured to prevent an additional predetermined projected area of said carrousel 16 to be reached. The mask 38 is fixed with regard to the chamber 12. The carrousel 16 is thus rotating with regard to the mask 38. When ions or vaporized material are provided by the vaporization means, the mask 38 is positioned between the vaporization means and the carrousel 16 so that the mask 38 prevents a portion of a row of articles 17 to be reached. The mask 38 is configured to provide a homogeneous deposition of the ions or vaporized material onto the articles 17 whatever the position of the articles 17. Hence, the shape of the mask 38 is configured so that the exposition time of the articles 17 to the ions or vaporized material is the same from the central to the peripheral portions of the carrousel 16. To do so, the mask 38 has a shape which allows to cover less and less the articles from the central to the peripheral portions of the carrousel 16, in percentage of articles 17 in a row. The mask 38 may have a leaf-like shape as shown on figures 3-7.

A leaf-like shape is defined by a first half having an increasing transversal dimension and a second half having a decreasing transversal dimension, as an elongated rhombus. The first half may be truncated to provide the first end with a greater transversal dimension.

Said mask is disposed between the carrousel 16 and the base surface 13, near the carrousel 16. Particularly, said mask is disposed between 50 and 100% of the distance defined above. Preferably, said mask is disposed between 70 and 100% of the distance

Said shut area 30 or predetermined projected area may define a covering rate corresponding to a number of articles covered by the screen 16 divided by a total number of articles 17 in a row. In other words, the shape of the screen 26 may be build-up as the mask to provide an even distribution of the ions or vaporized material from the central to the peripheral portions. The screen 26 may be formed so that the covering rate of each row among said plurality of rows decreases from the center to the peripheral portions.

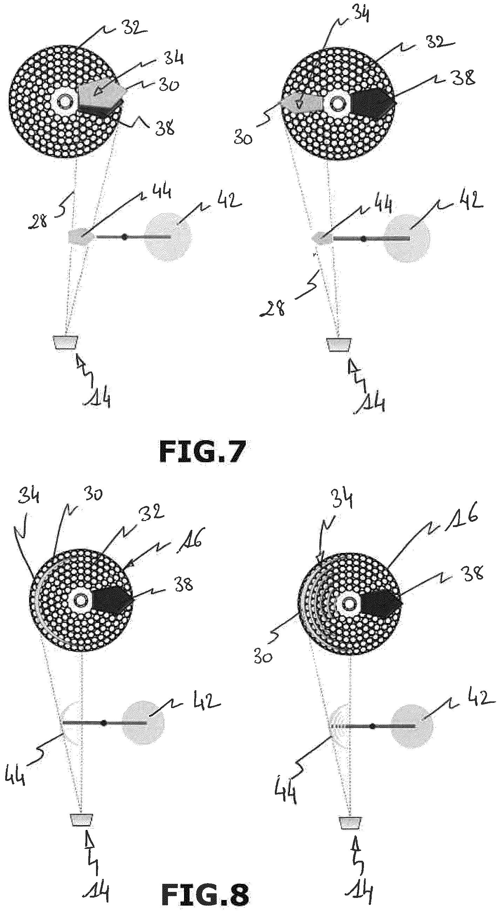

Figure 7 shows two embodiments of the screen 26 wherein the screen 26 has a leaf-like shape. We can see that the screen 26 may be used as a second mask to double the effect of the mask 38. Depending on where the shut area 30 is to be disposed onto the carrousel 16, the screen 26 may be differently oriented and positioned with regard to the rotational axis A of the carrousel 16.

Furthermore, as shown on figure 7, the shutter may comprise a first 42 and a second screens 44. The first screen 42 is configured to prevent any article 17 disposed onto said carrousel 16 to be reached by vaporization of material when disposed between said vaporization means and said carrousel 16. The second screen 44 is configured to prevent the shut area 30 or predetermined area of said carrousel 16 to be reached. Said shutter may be configured to be moved to either position said first or said second screens between said crucible assembly and said carrousel. Said first 42 and second 44 screens may be fixed to two opposite ends of the arm 27.

As shown on figure 8, the screen 26 (or second screen 44) may be shaped as a croissant to obtain a shut area 30 in the form of a croissant to be able to cover a part of a single row. The screen 26 may comprise a plurality of parts as shown on the right of figure 8 to form a discontinuous shut area 30.

## Claims

1. A physical vapor deposition machine for depositing a coating onto at least one article, comprising:
- a chamber forming a base surface,
- a crucible assembly disposed on said base surface,
- a carrousel configured to receive a plurality of articles disposed thereto so as to face said crucible assembly, said carrousel being configured to be rotated with regard to said crucible assembly,
- at least one vaporization means and/or at least one ion gun configured to generate a flow of ions or vaporized material towards the carrousel,
- at least one shutter of said flow of ions or vaporized material comprising at least one screen movable between:
• a first position wherein said at least one screen prevents any article disposed onto said carrousel to be reached by said flow of ions or vaporized material,
• a second position wherein said at least one screen allows all articles disposed onto said carrousel to be reached by said flow of ions or vaporized material,
said physical vapor deposition machine being **characterized in that** said at least one shutter of said flow of ions or vaporized material is configured to be positioned and locked at at least one intermediate position between said first and second positions, wherein said at least one screen prevents a predetermined area projected onto said carrousel to be reached by said flow of ions or vaporized material when said shutter is in said at least one intermediate position.

2. The physical vapor deposition machine according to claim 1, wherein said at least one shutter of said flow of ions or vaporized material prevents at least part, but not all, of the articles disposed onto said carrousel to be reached by said flow of ions or vaporized material when disposed in said at least one intermediate position.

3. The physical vapor deposition machine according to claim 1 or 2, wherein said at least one vaporization means comprises one or more among an electron beam gun and a thermal evaporator.

4. The physical vapor deposition machine according to any one of claims 1 to 3, further comprising a controller for controlling the position of the at least one shutter, said controller being further configured to set said at least one intermediate position of the at least one shutter.

5. The physical vapor deposition machine according to any one of claims 1 to 4, wherein said carrousel is configured to receive said plurality of articles in the form of a plurality of concentric rows, said predetermined projected area covering at least a part of at least one row of said plurality of concentric rows of said carrousel.

6. The physical vapor deposition machine according to claim 5, wherein said predetermined projected area covers at least a part of all rows of said carrousel.

7. The physical vapor deposition machine according to claim 6, wherein said carrousel is configured to be rotated around a rotation axis, said plurality of concentric rows being arranged around said rotation axis from a center portion to a peripheral portion of said carrousel, said predetermined projected area extending from said center to said peripheral portion.

8. The physical vapor deposition machine according to claim 7, wherein said predetermined projected area defines a covering rate corresponding to a number of articles covered by said at least one screen divided by a total number of articles in a row, said at least one screen is formed so that the covering rate of each row among said plurality of rows decreases from the center to the peripheral portions.

9. The physical vapor deposition machine according to any one of the preceding claims, wherein a distance is defined between said base surface corresponding to 0% and said carrousel corresponding to 100%, said at least one shutter of said flow of ions or vaporized material being disposed between 0 and 50% of said distance.

10. The physical vapor deposition machine according to any one of the preceding claims, further comprising a mask positioned nearby said carrousel and configured to prevent an additional predetermined projected area of said carrousel to be reached by said flow of ions or vaporized material.

11. The physical vapor deposition machine according to claim 10 in combination with claim 8, wherein said mask is disposed between 70% and 100% of said distance.

12. The physical vapor deposition machine according to any one of the preceding claims, wherein said flow of ions or vaporized material forms a cone of ions or vaporized material with a cone apex positioned at the base surface and a cone base positioned at the carrousel.

13. The physical vapor deposition machine according to any one of the preceding claims, wherein said at least one shutter comprises:
- a first screen configured to prevent any article disposed onto said carrousel to be reached by said flow of ions or vaporized material when disposed between said carrousel and said at least one vaporization means or said at least one ion gun,
- a second screen configured to prevent said predetermined area of said carrousel to be reached by said flow of ions or vaporized material when disposed between said carrousel and said at least one vaporization means or said at least one ion gun,
said at least one shutter being configured to be moved to either position said first or said second screens between said carrousel and said at least one vaporization means or said at least one ion gun.

14. A method for depositing a coating onto at least one article using a physical vapor deposition machine which comprises:
- a chamber forming a base surface,
- a crucible assembly disposed on said base surface,
- a carrousel configured to receive a plurality of articles disposed thereto so as to face said crucible assembly, said carrousel being configured to be rotated with regard to said crucible assembly,
- at least one vaporization means and/or at least one ion gun configured to generate a flow of vaporized material towards said carrousel,
- at least one ion gun generating a flow of ions directed towards said carrousel,
- at least one shutter of said flow of ions or vaporized material comprising at least one screen movable between:
• a first position wherein said at least one screen prevents any article disposed onto said carrousel to be reached by said flow of ions or vaporized material,
• a second position wherein said at least one screen allows all articles disposed onto said carrousel to be reached by said flow of ions or vaporized material,
said physical vapor deposition machine being **characterized in that** said at least one shutter of said flow of ions or vaporized material is configured to be positioned and locked at at least one intermediate position between said first and second positions wherein said at least one screen prevents a predetermined area projected onto said carrousel to be reached by said flow of ions or vaporized material when said shutter is in said at least one intermediate position,
said method comprising the following steps:
- disposing at least one article onto said carrousel,
- positioning and locking said at least shutter at said at least one intermediate position,
- activating said at least one ion gun or at least one vaporization means to respectively generate a flow of ions or vaporized material towards said carrousel, said at least one shutter preventing said predetermined projected area of said carrousel to be reached by said flow of ions or vaporized material.
